# EUROPEAN PATENT SPECIFICATION

(11) **EP 1 037 345 B1**
(45) Date of publication and mention of the grant of the patent: **15.01.2003**
(21) Application number: 00104390.0
(22) Date of filing: 02.03.2000
(51) Int. Cl.: H01T 4/12, H01T 21/00

(54) **Surge absorber without chips**
Überspanningsableiter ohne Chips
Dérivateur de surtensions sans puces

(30) Priority: 16.03.1999 JP 6966299
(43) Date of publication of application: 20.09.2000
(73) Proprietor: Yang, Bing Lin, Tokyo 135-0002 (JP)
(72) Inventor: Yang, Bing Lin, Tokyo 135-0002 (JP)
(74) Representative: Heim, Hans-Karl, Dipl.-Ing.

(56) References cited:
- FR-A- 2 484 695
- US-A- 4 727 350
- PATENT ABSTRACTS OF JAPAN vol. 1999, no. 11, 30 September 1999 (1999-09-30) & JP 11 154585 A (MITSUBISHI MATERIALS CORP), 8 June 1999 (1999-06-08)
- PATENT ABSTRACTS OF JAPAN vol. 1997, no. 10, 31 October 1997 (1997-10-31) & JP 09 171881 A (KONDO DENKI:KK), 30 June 1997 (1997-06-30)

## Description

### BACKGROUND OF THE INVENTION

### 1. Field of the Invention

The present invention relates to an electronic element, and in particular, to a surge absorber without chips.

### 2. Description of the Background Art

Stray waves, noise, and electrostatic disturbances which may cause surges are deeply-rooted obstacles to the most up-to-date electronic devices. In particular, high voltage pulse waves cause erroneous operations of semiconductor elements in electronic devices, and sometimes even damage the semiconductors or the devices themselves. Such problems can, however, be solved by the use of surge absorbers.

A conventional surge absorber comprises a discharge chip or discharge core having an insulating microgap, and this discharge chip is sealed in a glass housing. For example, in a microgap surge absorber manufactured by Mitsubishi Materials K.K., a thin conductive film is developed on a ceramic core, and cap-shaped metal electrodes are fixed on both ends of the core. Subsequently, the surface of the thin conductive film is removed by laser beam, forming a slit, or a microgap. A discharge chip (discharge core) formed in this way is then sealed in a glass tube. Accordingly, in such a conventional chip type surge absorber, discharge voltage can be determined by the width of the microgap (the groove in a form of a thin slit).

Further conventionally known is a surge absorber constituted by conductive films partitioned by microgrooves. However, as it is difficult to freely select a switching voltage in surge absorbers of this type, uses thereof are severely limited. To overcome this problem, U.S. Patent No. 4,727,350 discloses a surge absorber comprising a cylindrical tube core covered with a conductive film having intersecting microgrooves, and sealed in a glass container.

In Japanese Patent Laid-Open Publication No. Hei 8-306467, the applicant of the present invention similarly proposed a surge absorber solving the conventionally existing problems described above. In this surge absorber, a tube core is arranged between a pair of electrodes sealed in a housing, and an inert gas is filled in the surrounding air chamber around the core. This arrangement permitted surge absorption to a higher switching voltage than was conventionally possible.

However, each of the surge absorbers described above is constituted by forming a discharge chip or discharge core (tube core) to first determine the discharge characteristic, and then sealing this chip or core in a housing. The structure is therefore complex and requires many manufacturing processes, making it difficult to reduce production costs. Especially in recent years, many surge absorbers must be mounted in an electronic equipment to protect elements inside and to cope with fluctuations in power supply voltage. In this situation, the problem exists wherein the number of surge absorbers used leads directly to the increase in cost of the overall equipment.

Moreover, in the conventionally proposed surge absorbers, a discharge current flows via a tube core. These surge absorbers are therefore unable to cope with a high switching voltage of, for example, 10,000 volts, and cannot completely absorb a surge of large energy at the time of surge absorption. This causes the problem that, due to the residual voltage, a follow-current (a current, caused by a residual voltage, that flows into the electronic equipment to be protected) is generated in the circuitry. Further, in conventional devices, it is a problem that the switching voltage varies depending on the specification of the tube core.

To solve the above problems, the applicant of the present invention filed Japanese Patent Application No. Hei 10-189486 published on 21.01.2000 under number JP-A-2 000 021 608 providing a surge absorber which can easily be manufactured in large quantities due to its remarkably simple structure and.which is applicable to a wide range of surge voltage and maximum surge current.

According to this prior-filed invention, an improved surge absorber was provided that can perform surge absorption over a wide range of switching voltages. The improved surge absorber instantaneously absorbs a large amount of energy because resistance at the time of surge absorption is extremely reduced. Any residual voltage is reliably eliminated that conventionally remained after surge absorption, and accordingly, generation of follow-current by residual voltage is prevented. Further, this surge absorber can be finely adjusted for a variety of discharge voltage, discharge speed, and surge withstand amount (surge current) by arbitrarily designing each part of the surge absorber.

The surge absorber of the prior-filed invention is characterized in that a pair of discharge electrodes having lead terminals are arranged facing one another at a predetermined distance, and, while maintaining the predetermined distance, a housing is melted at both ends and the ends are welded to the electrodes or the lead terminals.

In the prior-filed invention, the pair of discharge electrodes are thus accurately held in an arrangement such that they face one another at a predetermined distance in the housing. While maintaining this arrangement, the housing is heated, and the electrodes or the lead terminals are sealed to the housing by welding. In this way, it is possible to arbitrarily select the distance between the two discharge electrodes, and precise adjustment of the distance is facilitated.

However, in the above-described background art, a variety of discharge electrodes having different diameters must be employed to provide surge absorbers for varying levels of surge voltages. Characteristics of a surge absorber, especially surge voltage and maximum surge current, do depend on a variety of factors such as the gap between the facing pair of discharge electrodes, the size of the air chamber, and the shape of the electrodes. However, the diameter of discharge electrodes is a strong factor determining the surge absorber characteristics. A variety of discharge electrodes having different diameters must therefore be provided to deal with varying levels of surge voltages.

As a typical closest prior art surge absorber without chips, there is known, for example, a gas tube arrester manufactured by Ishizuka Electronics K.K. In this conventional device, electrodes are arranged facing one another and maintained a predetermined distance apart by an insulating material such as glass. However, in this gas tube arrester, the distance between the facing electrodes is determined by the length of the insulating tube, and the insulating tube and the electrodes are welded together. This structure requires preparation of a great variety of insulating tubes having different lengths in order to provide different types of facing electrode pairs, namely, facing electrodes separated by varying distances. Using this structure, it is therefore practically impossible to obtain a surge absorber without chips that is applicable to a wide range of discharge voltages and maximum surge current. Further, as the insulating tube is made of glass and the distance between the electrodes is determined by the length of the insulating tube, the crucial distance between the electrodes fluctuates if the insulating tube and the electrodes are welded by heating. Under these circumstances, heat welding cannot be used, and fusing must be performed at the contacting surfaces of the insulating tube and the electrodes. During the fusing process, the air chamber becomes severely contaminated by flux or the like, resulting in extreme deterioration of the discharge characteristics.

From FR-A-2 484 695 a surge arrester is known which comprises a pair of lead terminals which are held by sealing spacers at a predetermined distance in a metal housing. On the metal housing an elastic metal device is fixed which has two elastic strips. Between the elastic strips and the metal housing fusable elements are provided whereby folded ends of the elastic strips are spaced from the lead terminals. As soon as a high voltage acts on one of the lead terminals the electrical current is transferred to the metal housing whereby the fusable elements are melted. Due to the melting of the fusable elements the elastic metal device comes into contact with the lead terminals so that the electrical current can flow via the elastic metal device between the lead terminals.

The object of the present invention is to provide and improved surge absorber having a simple structure and being capable of easily providing multiple types of surge absorbers to deal with a wide range of a surge characteristics.

The object is achieved by a surge absorber having the features of claim 1.

Further, to accomplish the above object, the present invention offers a surge absorber comprising a pair of lead terminals having broadened tips forming discharge electrodes, sealing spacers fitted and fixed on lead portions of the lead terminals and a housing. The pair of lead terminals each having the sealing spacers fixed thereon are inserted from open ends on both sides of the housing, and the two sealing spacers are welded on an inside wall of the housing while the discharge electrodes are held in position facing one another at a predetermined distance.

According to the present invention wherein the discharge electrodes are formed by broadening the tips of the lead terminals, discharge electrodes having a variety of sizes can be obtained from lead terminals having identical diameters by changing the degree of the broadening. Moreover, as the discharge electrodes of the present invention do not need to be fixed on the housing, discharge electrodes of different diameters can be placed inside housings having common sizes. By using lead terminals and housings both having identical diameters, and by selecting a variety of sizes of broadened diameters for lead terminal tips, surge absorbers corresponding to different levels of surge voltages can be provided easily.

Further, according to the present invention, the housing and the sealing spacers are fixed, or alternatively, the housing is heated to fuse with the sealing spacers, while the relative positions of the pair of lead terminals having the discharge electrodes are precisely maintained. In this way, the present invention is advantageous in that precise relative positioning of various types of electrodes can be accomplished very easily.

In another aspect, the surge absorber of the present invention is characterized in that an air chamber in the housing is filled with clean, dry air, or a mixed gas comprising clean, dry air and an inert gas or hydrogen gas.

According to this aspect of the present invention, a pair of discharge electrodes are sealed inside the housing while being separated by a predetermined air gap, and the air chamber is filled with clean, dry air or a gas mixture comprising clean, dry air and an inert gas or hydrogen gas. With this extremely simple structure, the surge absorber can adequately deal with a surge at a high switching voltage. Moreover, as gas resistance in the air chamber is notably low at the time of insulation discharge, the operational resistance can be extremely low when the dielectric breakdown of the gas is caused by a surge voltage. Therefore, a surge can be absorbed instantaneously even at a high switching voltage, thus effectively preventing generation of typical residual voltage. Whereas a surge absorber having a gap of normal air disposed between electrodes is conventionally known as the above-mentioned gas tube arrester, the air sealed in the air chamber of the present invention is sufficiently clean and dry air. Dielectric breakdown therefore occurs in the air chamber maintained in a stable condition between the facing electrodes, thus securely providing a very useful surge absorption path.

Further, according to the present invention, the clean, dry air sealed in the air chamber may have a relative humidity of 5% or less, and a degree of cleanliness of 99.99% (0.5 µmDOP), which is higher than the degree of cleanliness obtained through filtering normal air.

It is to be understood that, instead of the clean air, an inert gas or an active gas such as hydrogen can be sealed in the air chamber of the present invention. Using air including 1 to 10% hydrogen, results were obtained wherein the discharge voltage tended to be lower and the response speed of discharge became faster. Further advantageously, the air in the air chamber is cleaned by the reduction effect of hydrogen gas, thus preventing deterioration of discharge characteristics even after a large number of discharge operations, and thereby enabling stable surge absorption.

Another feature of the present invention is that the sealing spacers may be in the shape of a glass or plastic sphere with a central fitting through-hole, and may also have the shape of a flat cylinder (a disk) instead of a sphere. These sealing spacers are heated while the lead portions of the lead terminals are inserted in the fitting through-holes, and the sealing spacers and the lead terminals are thus easily bonded by welding. When using disk-shaped sealing spacers, the spacers can be entirely reshaped into spheres when heated during welding mentioned above. Such spherical sealing spacers are advantageous in that they can very easily be inserted into the housing.

In consideration of the welding of the sealing spacers and the lead terminals, the lead terminals are preferably formed of Dumet wires. When the lead terminals are required to be long, it is also preferable to use a combined lead wire, in which only the lead portions to be welded to the sealing spacers are formed of Dumet wires, and other portions are formed of a typical, inexpensive material such as iron.

Moreover, in the surge absorber without chips of the present invention, at least one of the pair of discharge electrodes may have a flat discharge surface contacting the air gap.

The housing of the surge absorber without chips of the present invention may comprise a glass ceramic or plastic container.

Air to be sealed in the air chamber according to the present invention is, as explained above, not typical air but clean and dry air. Its degree of cleanliness is 99.99% (0.5 µmDOP), which is higher than the degree of cleanliness obtained through filtering normal air. With regards to dryness, relative humidity is 5% or less, preferably 3% or less. Further, for example, to adjust the surge switching voltage, it is possible to mix inert gases in the air to be sealed in the air chamber as necessary. Argon or neon are preferably used as an inert gas to be mixed. Nitrogen can also be used instead of these inert gases.

The above-described surge absorber without chips can be used widely in extremely complex electronic circuits that are important components for resetting computers operating at a high speed using large-capacity memories. The use of the surge absorber can effectively eliminate influences of surge waves generated by frequent ON/OFF operations of computer displays and other electronic devices.

Moreover, the surge absorber without chips according to the present invention can also be used in devices to be connected to telephone lines, such as a telephone set, a radio, a facsimile, a modem, and a program-controlled telephone switching device, devices to be connected to antennas or signal wires, such as an amplifier, a tape recorder, a vehicle radio, a radio transceiver, and a sensor signal wire, devices requiring prevention of static electricity, such as a display and a monitor, domestic appliances, and computer controlled electronic devices. The surge absorber without chips of the present invention also functions as an over-voltage prevention device. In other words, the surge absorber is an electronic element effective for counteracting hazardous influences of electric noise.

### BRIEF DESCRIPTION OF THE DRAWINGS

The present invention will be further understood from the following description with reference to the accompanying drawings in which:
Fig. 1 is a diagram illustrating the basic structure of a surge absorber of the present invention;
Fig. 2 is a diagram showing another preferred embodiment of the surge absorber of the present invention;
Fig. 3 is a diagram showing a further preferred embodiment having a structure similar to that of Fig. 2;
Fig. 4 is a diagram explaining the pressing process for forming discharge electrodes at the tips of the lead terminals according to the present invention;
Fig. 5 is a diagram for further explaining the pressing process illustrated in Fig. 4, showing a discharge electrode formed at the tip of a lead terminal;
Fig. 6 is a diagram illustrating that discharge electrodes having a variety of diameters can be inserted into a common housing according to the present invention;
Figs. 7A and 7B show the assembly processes of a surge absorber of the present invention;
Figs. 8A and 8B show the assembly processes of a surge absorber of the present invention having another shape;
Fig. 9 is a diagram illustrating another embodiment in which a protruding portion is disposed on one of the discharge electrodes;
Fig. 10 is a diagram illustrating a conical protruding portion on one of the discharge electrodes;
Fig. 11 is a diagram showing conical protruding portions disposed on the surfaces of both of the discharge electrodes;
Fig. 12 is a diagram of an embodiment having conical concavities disposed on both of the discharge electrodes;
Fig. 13 is a diagram of an embodiment of the present invention having discharge electrodes of different shapes;
Fig. 14 is a diagram of an embodiment having arc-shaped surfaces on both of the discharge electrodes;
Fig. 15 is a diagram showing an example press die for machining the tips of lead terminals;
Fig. 16 is a diagram showing a discharge electrode formed by the press die shown in Fig. 15;
Fig. 17 is a diagram illustrating another preferred embodiment of a lead terminal of the present invention;
Fig. 18 is a diagram showing the surge absorber of the present invention in a packaged state;
Fig. 19 is a graph showing a waveform of a surge applied to the present invention; and
Fig. 20 is a characteristic graph illustrating the state when the surge voltage of Fig. 19 is absorbed by the present invention.

### DESCRIPTION OF PREFERRED EMBODIMENTS

Preferred embodiments of the present invention will now be described referring to the accompanying drawings.

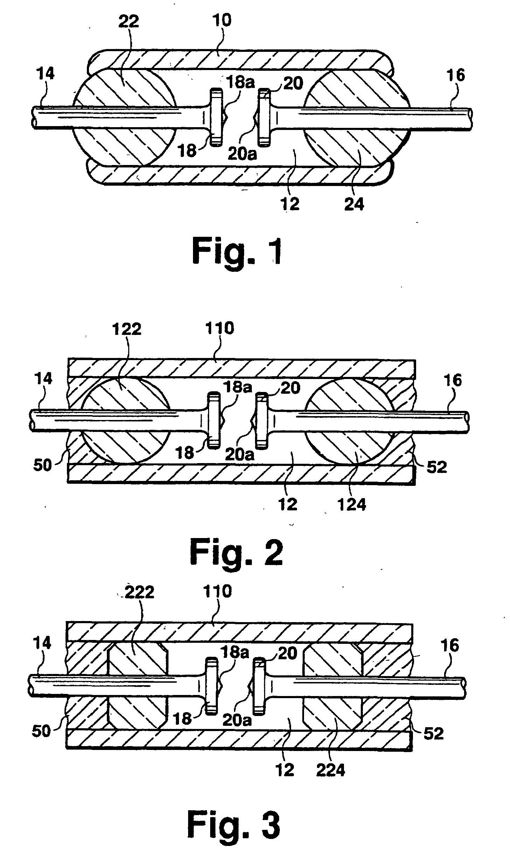

Fig. 1 shows a preferred embodiment of a surge absorber without chips of the present invention. A housing 10 comprises a glass or plastic cylinder, and an air chamber 12 is provided inside the housing. Lead terminals 14,16 are inserted from openings on both ends of the housing 10. In the air chamber 12, discharge electrodes 18,20 formed by broadening the diameter of the tips of the lead terminals 14,16 are arranged facing one another at a predetermined distance.

The feature of the present invention is that the discharge electrodes 18,20 are formed by broadening the diameter of respective tips of the lead terminals 14,16. The broadening process is described later in detail.

Protruding portions 18a,20a are formed in the center of each of the discharge electrodes 18,20. With this arrangement, when a surge voltage is applied to the lead terminals 14,16, a stable discharging easily occurs between the protruding portions 18a, 20a. Both of the discharge electrodes 18,20 are formed by broadening the leads into disk shapes. The diameters of the electrodes can be selected as desired during the broadening process. Through the selection of desired diameters in addition to desired gaps between the discharge electrodes 18,20, surge absorbers corresponding to a variety of different surge voltages can be obtained. To precisely maintain the lead terminals 14,16 in position inside the housing 10, the lead terminals 14,16 are provided with sealing spacers 22,24 fixed by welding. The lead terminals 14,16 having the sealing spacers 22,24 are inserted into the housing 10 from the openings on both ends of the housing 10. In that state, the sealing spacers 22,24 and the housing 10 are heated, and the spacers and the housing become welded to each other as shown in the Figure.

In a typical example, when fusing the sealing spacers 22,24 to the lead terminals 14,16, a burner can be used to perform welding at a heating temperature of, for example, 350 to 850°C. In contrast, when heat welding the sealing spacers 22,24 precisely held in position in the housing 10, it is preferable to execute the heating to the similar temperature of 350 to 850°C in a slow manner.

To facilitate welding to the sealing spacers 22,24, the lead terminals 14,16 of the present invention are preferably formed of Dumet wires, for example. A Dumet wire comprises a core wire material made of iron-nickel alloy, plated on its surface by a plating material mainly composed of copper and a nitrate. This copper component and the sealing spacers 22,24 made of glass are firmly welded to each other.

As is apparent from Fig. 1, the discharge electrodes 18,20 of the present invention need not be fixed directly to the housing 10. A large air chamber 12 can therefore be secured inside the housing 10, rendering the discharge characteristics stable. Another advantage is that housings 10 having a common size can be used for discharge electrodes 18,20 having different diameters, as explained above.

The present invention employs the principle of electrical energy consumption and absorption through conversion of electrical energy into light energy, and effectively absorbs high voltage stray waves and surge pulses. The reaction characteristic of this absorber inherently differs from the luminous effect of a LED (light-emitting diode) or a discharge tubes which gradually weakens from high luminance to extinction.

As described above, according to the embodiment of the surge absorber without chips of the present invention shown in Fig. 1, the air chamber 12 is provided between the discharge electrodes 18,20 arranged facing one another inside the housing 10. When a surge voltage is applied between the discharge electrodes 18,20, dielectric breakdown occurs in the air chamber 12, and the surge energy is thereby converted and absorbed.

As can be seen in Fig. 1, conventional discharge chips or discharge cores are not used in the present invention. As explained above, the surge absorber without chips of the present invention simply comprises a pair of discharge electrodes 18,20 arranged facing one another inside a housing 10. To put this simple structure into actual practice, the present invention is constituted by arranging the lead terminals 14,16 having the pair of discharge electrodes 18,20 inside the housing facing one another. In a typical procedure, one of the lead terminals 14 is inserted into a hole formed in an underlying jig, and, at the same time, the housing 10 is also placed in the hole.

In this inserted state, as the outer diameter of the sealing spacer 22 of the present invention is selected to be slightly smaller than the inner diameter of the housing 10, there is no difficulty in placing the sealing spacer 22 inside the housing 10. At this point, the first lead terminal 14 and the housing 10 stand upright in the underlying frame.

Subsequently, the other lead terminal 16 is inserted into a hole formed in an upper frame. The upper frame is then positioned contacting the lower frame. In this state, where the upper and the lower frames are adhered to each other, as the outer diameter of the other sealing spacer 24 is also slightly smaller than the inner diameter of the housing 10, the other discharge electrode 20 sustained in the upper frame falls perpendicularly to become positioned against the surface of the first electrode 18.

Subsequently, the other discharge electrode 20 placed by the upper frame is pulled upward by a predetermined distance and maintained in that position. Any appropriate mechanism can be used for this pulling up and maintaining operation, but the distance of the pulling up must be precisely controlled according to the required accuracy. When preparation is completed in such a manner, the distance between the discharge electrodes 18,20 should be accurately adjusted to a predetermined value.

The upper and the lower frames are then placed in a high temperature state. Alternatively, the above-described preparatory assembly procedure is performed at a high temperature from the beginning. The sealing spacers 22,24 and the housing 10, together with the upper and the lower frames, are thus heated. When heated at 350 to 850°C, the sealing spacers 22,24 and the housing 10 typically melt and become firmly welded at both ends of the housing as shown in Fig. 1. According to the present invention, the upper and the lower lead terminals 14,16 are accurately held in position in the jig during the heating at a high temperature and the subsequent cooling. As the welding to the housing 10 is carried out while the gap between the electrodes are maintained as such, it should be apparent that an accurate gap between the discharge electrodes can be provided as shown in Fig. 1 according to the present invention.

Further according to the present invention, this gap can be controlled to any distance by appropriately adjusting the distance between the discharge electrodes sustained in the upper and the lower frames. Unlike the conventional gas tube arrester, a wide variety of surge absorbers without chips can be obtained very easily and accurately.

Another feature of the present invention is that gas sealed in the air chamber 12 is clean, dry air, or a mixture of clean, dry air and an inert gas or hydrogen.

Preferably, the cleanliness of the air is 99.99% (0.5 µmDOP), which is higher than the degree of cleanliness obtained through filtering normal air. With regards to dryness, relative humidity is preferably kept at 5% or less, more preferably at 3% or less.

In the present embodiment, normal air was. filtered by an ATOMOS Ultra ULPA Filter manufactured by Nippon Muki K.K., and up to 99.9999% of particulates as small as 0.05 µm therein were collected. Air obtained as such was accumulated and used.

By using such clean, dry air, the dielectric breakdown voltage of the air chamber becomes extremely stable. More specifically, in the dielectric breakdown of the present invention, a spark of dielectric breakdown is generated on a part of the protruding portions 18a,20a in the air chamber 12 shown in Fig. 1 when a surge voltage applied between the discharge electrodes 18,20 exceeds a predetermined switching voltage. This dielectric breakdown instantaneously extends to the entire air chamber 12. As clean, dry air is uniformly subject to dielectric breakdown in an extremely short period of time, a large insulating current can flow between the discharge electrodes in the present invention.

As previously described, the surge absorber without chips of the present invention comprises the facing discharge electrodes 18,20 arranged in the air chamber without any insulators disposed therebetween. It is therefore possible to eliminate occurrence of the unfavorable conventional phenomena of substantial decrease in the distance between the discharge electrodes due to adhesion of copper molecules to the surface of the insulator generated at the time of discharge. A stable surge absorber with a long service life is thus provided by the present invention.

In the present invention, the switching voltage, the insulating current (maximum surge current), and the operating speed are mainly determined by the volume of the air chamber 12, the gap length between the discharge electrodes 18,20, the diameter of the discharge electrodes, and the type and the pressure of the gas sealed. By altering any of these factors, surge absorbers having a variety of ranges of surge switching voltages can be obtained as desired. For the above-described embodiment illustrated in Fig. 1, switching voltages of approximately 50 to 15,000 volts or higher can be selected by appropriately choosing those factors.

The following table indicates typical examples of the distance between the discharge electrodes and the switching voltages according to the present invention.

**Table 1**

| Distance between discharge electrodes (mm) | DC discharge voltage (V) |
|---|---|
| 0.04 | 120 - 400 |
| 0.08 | 200 - 500 |
| 0.12 | 300 - 700 |
| 0.15 | 400 - 800 |
| 0.2 | 500 - 1,000 |
| 1.0 | 700 - 1,200 |
| 1.5 | 1,000 - 1,500 |
| 2.0 | 1,200 - 2,000 |
| 2.5 | 1,800 - 3,200 |
| 3.2 | 2,500 - 6,000 |
| 3.9 - 4.3 | 4,000 - 12,000 |
| 4.5 - 4.8 | 8,000 - 15,000 |
| 5.2 - | 15,000 - |

A characteristic effect of the present invention is that, due to the clean, dry air, the allowable current density in the air chamber 12 at the time of dielectric breakdown can be notably increased. This means that the resistance of the clean, dry air is low at the time of dielectric breakdown.

As dielectric breakdown occurs instantaneously and a large discharge current is allowed between the discharge electrodes 18,20, surge energy can be converted and absorbed instantaneously even when a high surge voltage is applied. Accordingly, it is possible to reliably eliminate the conventional disadvantages such as the occurrence of residual voltage and the continued existence of follow-current due to the residual voltage.

As the glass cylinder forming the housing 10 of the present invention, it is preferable to use, for example, a glass diode container of International Standard Type DO-34 with an inner diameter of 0.66mm. The lead terminals 14,16 are placed in the housing 10 from its both ends in a manner suitable for this inner diameter. The above-described sealing procedure is carried out in a room with clean, dry air. As a result, clean, dry air is sealed inside the air chamber 12. Other plastic or shrink plastic materials can also be used for the housing 10.

Further, it is possible to use a container of International Standard Type DO-35 (inner diameter 0.76mm) or Type DO-41 (inner diameter 1.53mm) as the housing 10. For a surge absorber with a large capacity, a glass diode container with an outer diameter of 9.0mm can be used. Moreover, the clean, dry air to be sealed in the air chamber 12 may be mixed with argon, neon, helium, and nitrogen. By appropriately selecting the ratio of the mixing, surge voltage, maximum surge current, or reaction speed can be adjusted as desired.

According to the arrangement of the present invention wherein clean, dry air is sealed in the air chamber 12 as described above, when any surge voltage is selected from among 50 to 15,000 volts, operating accuracy at each set voltage can be controlled within a range of approximately 10 volts by altering the surge characteristics by mixing the several gases mentioned above. The fact that such very fine adjustment is possible indicates that,. as the sealed air is clean and dry, the distribution of molecules constituting the air inside the air chamber 12 is extremely uniform. Accordingly, the surge voltage once set by the volume of the air chamber 12 or the pressure or the type of the gas sealed is very stable.

Moreover, as the air is clean and dry, its resistance at the time of insulation is very low. The allowable surge current at the time of dielectric breakdown can therefore be large, permitting instantaneous absorption of surge energy even when a high surge voltage is applied. For example, using a surge absorber of the above-mentioned Japanese Patent Laid-Open Publication No. Hei 8-306467, if the surge voltage is set at 6,000 volts, a surge current of 1,050 amperes can be discharged by the surge absorber when a voltage of 10,500 volts is applied. However, even after the surge absorption, a residual voltage of 4,500 volts remains, resulting in generation of a follow-current of 450 amperes in the circuit. In contrast, under an identical condition, almost no residual voltage or follow-current results when using the surge absorber of the present invention.

Fig. 2 shows another embodiment of the surge absorber without chips of the present invention. This embodiment differs from the above-described embodiment shown in Fig. 1 in the manner of bonding of lead terminals 14,16 and the sealing spacers 122,124, and of the respective sealing spacers 122,124 and the housing 110.

In this embodiment, the sealing spacers 122,124 are composed of a plastic material and fixed on each of the lead terminals 14,16 through formation using a mold. In the process of formation using a mold, as is known, the lead terminals 14,16 are fixed in spherical molds, and plastic material is injected therein. In this way, each of the sealing spacers 122,124 is formed into one unit with a corresponding lead terminal.

The unit comprising the lead terminal 14 and the sealing spacer 122, and the other unit comprising the lead terminal 16 and the sealing spacer 124, are inserted from the open ends on both sides of the housing 110, and accurately positioned by a predetermined jig such that a precise distance is maintained between the facing discharge electrodes 18,20. In this embodiment, the housing 110 is also made of plastic. In the accurately positioned state as described above, melted plastic is injected in both of the open ends of the housing 110 as shown by numerals 50,52, thereby securely sealing the open ends in an airtight manner. It is to be understood that other appropriate adhesives may be used for the seals 50,52 in this embodiment.

Further, in this embodiment, the sealing spacers 122,124 and the housing 110 may also be formed of other appropriate materials, such as ceramic materials.

Fig. 3 illustrates another alternative embodiment of the surge absorber without chips of the present invention. Although this embodiment has a structure similar to that shown in Fig. 2, the sealing spacers 222,224 are in a shape of either a cylinder (disk) or a rectangular plate, and, matching this shape, the housing 110 is in a shape of a hollow cylinder or a hollow rectangular block. The materials which the components are made of, and the method of assembly, correspond to the embodiment of Fig. 2.

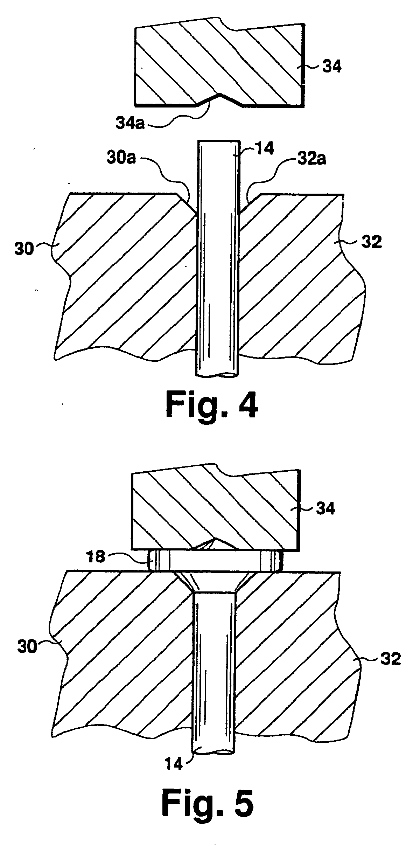

Figs. 4 and 5 illustrate the process of broadening the diameter of the lead terminal tips according to the present invention.

In Fig. 4, a Dumet wire cut into a predetermined length is used as the lead terminal 14. This lead terminal 14 is firmly held by clamps 30, 32. The clamps 30,32 comprise claws that part in two for gripping onto the lead terminal 14. Disposed on each of the holding portions of the claws is a semicircular groove for fitting the lead terminal 14. The lead terminal 14 is held inside the semicircular grooves. Conical receiving surfaces 30a,32a are disposed on the upper surfaces of the clamps 30,32.

A press die 34 is located above the clamps 30, 32. A conical concavity 34a is formed on the press die 34 at a position matching the axis of the lead terminal 14.

While in the state shown in Fig. 4, the press die 34 is pressed against the tip surface of the lead terminal 14. The diameter of the tip of the lead terminal 14 is thereby broadened as shown in Fig. 5. In this way, the discharge electrode 18 is formed on the tip of the lead terminal 14. During the above forming process, the outer diameter of the discharge electrode 18 can be selected as desired by adjusting the length of protrusion of the lead terminal 14 above the clamps 30,32 in the state shown in Fig. 4.

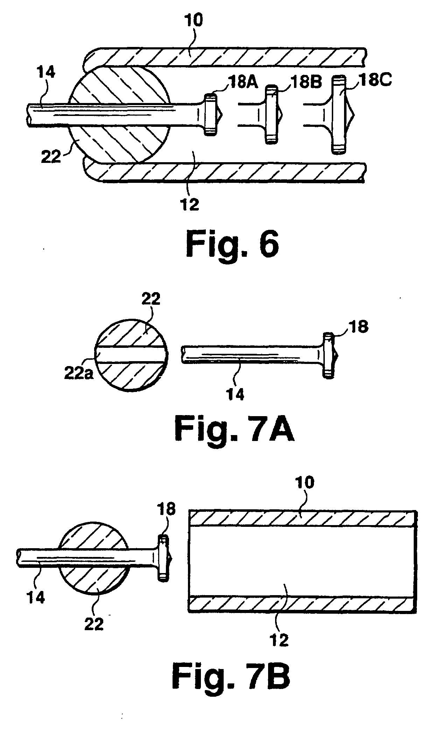

In this way, as previously mentioned, even when using lead terminals 14 having identical diameters, discharge electrodes 18 can be formed to have several different diameters 18A,18B,18C as shown in Fig. 6. These discharge electrodes with different diameters are easily inserted into housings 10 having identical diameters, thus providing surge absorbers that can deal with a wide variety of surge voltages.

Fig. 7A illustrates the process of welding a lead terminal 14 and a sealing spacer 22, and Fig. 7B illustrates the process of inserting the sealing spacer 22 into a housing 10.

In the present embodiment, a glass sphere is used as the sealing spacer 22. A fitting through-hole 22a is disposed in the center of the glass sphere 22. From the state shown in Fig. 7A, the lead terminal 14 is inserted into this fitting through-hole 22a. A discharge electrode 18 is already formed on the tip of the lead terminal 14 as shown in Figs. 4 and 5 explained above.

The lead terminal 14 and the sealing spacer 22 are welded together by heating. After those two components are formed into one unit as shown in Fig. 7B, the sealing spacer 22 is inserted from the opening of the housing 10 into the air chamber 12. By further heating at this point, the housing 10 and the sealing spacer 22 are welded and fixed as shown in Fig. 1.

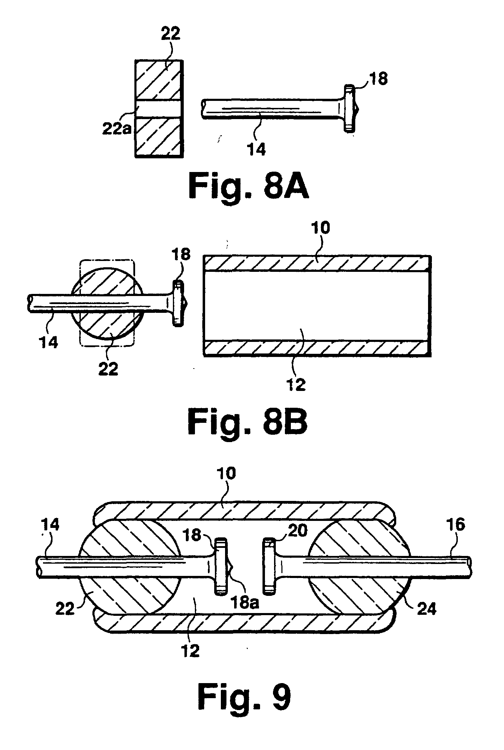

According to the present invention, the sealing spacer 22 is not necessarily spherical. In Figs. 8A and 8B, a cylindrical (disk-shaped) sealing spacer 22 is used. As illustrated in Fig. 8A, a lead terminal 14 is inserted into the fitting through-hole 22a of the sealing spacer 22, and the sealing spacer 22 and the lead terminal 14 are welded together by heating as described above. In addition to being welded to the lead terminal 14 by heating, the sealing spacer 22 indicated by a dotted line in Fig. 8B changes its shape to a sphere indicated by a solid line when heated. The sealing spacer 22 can therefore be easily inserted into the housing 10 in a similar manner as in Fig. 7.

The cylindrical sealing spacer 22 shown in Fig. 8 is advantageous in that such a spacer can be obtained more easily at a lower cost compared with a spherical spacer.

Fig. 9 shows an embodiment similar to that shown in Fig. 1, and detailed descriptions will therefore be omitted here. The feature illustrated in Fig. 9 is that a protruding portion 18a is disposed on the surface of only one of the discharge electrodes 18. In the present embodiment, this one-sided protruding portion 18a induces dielectric breakdown in the air chamber 12 and allows stable setting of surge voltage level.

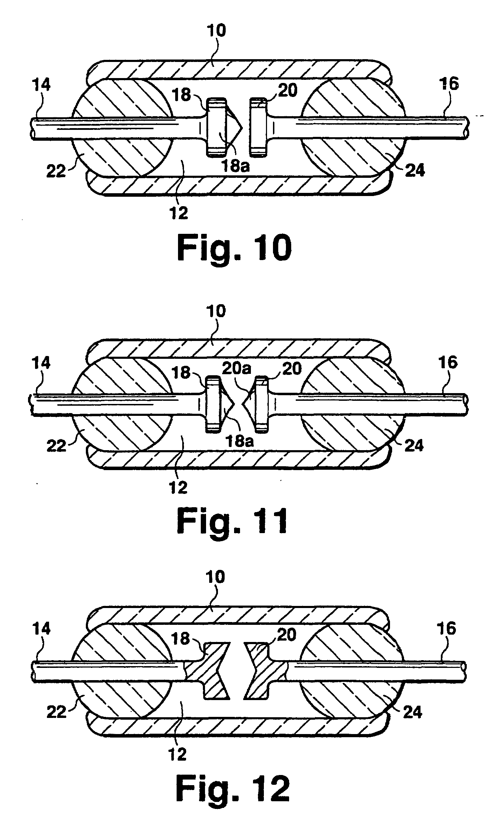

Fig. 10 shows a further different electrode shape. The entire surface of one discharge electrode 18 is in the shape of a cone, and its vertex forms the protruding portion 18a approaching closest to the other electrode 20. This embodiment is advantageous in that even when the tip of the protruding portion 18a is made to closely approach the other discharge electrode 20, the volume of the air chamber 12 is sufficiently large, permitting a large maximum surge current.

The embodiment shown in Fig. 11 has the structure in which the conical discharge electrode on one side in the above-described Fig. 10 is arranged on both sides. In this embodiment, as the conical vertices of the two discharge electrodes 18,20 are located close to one another, the surge switching voltage can be lowered. Another advantage of this embodiment is that as the volume of the air chamber 12 can be made large, the electrostatic capacity of the surge absorber can be reduced and the maximum surge current can be increased.

The embodiment shown in Fig. 12 comprises two discharge electrodes 18,20 each having a conical concavity. The resulting advantage is that the air chamber 12 becomes almost completely optically shielded from the outside. Specifically, in the embodiment of Fig. 12, such an electrode shape eliminates the so-called "brightness effect" in which the surge voltage of a surge absorber varies due to incoming light. In general, when external light is strong, the surge voltage of a surge absorber tends to rise. However, in the present embodiment, entering of light into the air chamber 12 from outside is reduced. Therefore, even when external light is strong, the conventional brightness effect can be minimized.

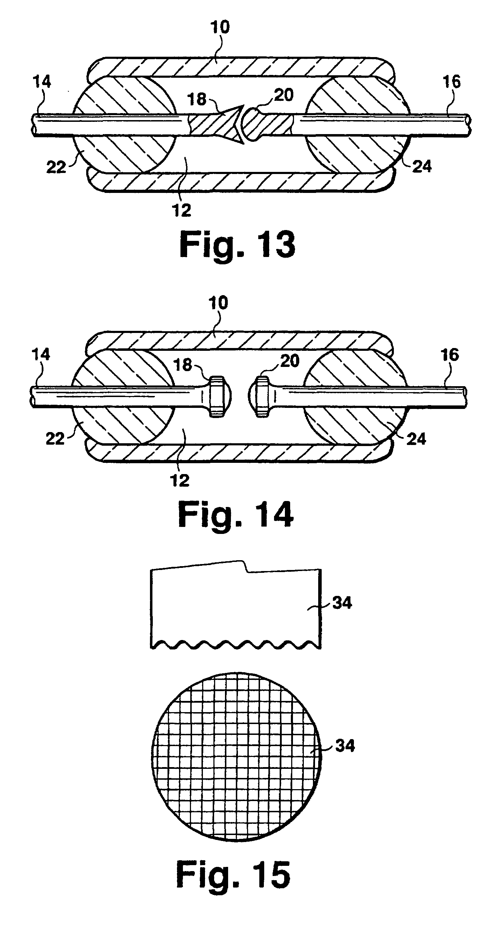

Fig. 13 shows a variation example of the embodiment of Fig. 12. According to this variation example, the two discharge electrodes 18,20 are such that one has a convex surface and the other has a corresponding concave surface. By using such surface shapes for the discharge electrodes 18,20, the volume of the air chamber 12 can be arbitrarily selected, which determines the length of the gap inducing discharge and the maximum surge voltage.

Fig. 14 shows another surface shape for the discharge electrodes 18,20. In this variation example, the surfaces of the discharge electrodes 18,20 are formed in the shape of an arc. As shown, in the present invention, the tips of the discharge electrodes need not be in the shape of pointed protruding portions. Sufficiently successful discharge operation can similarly be performed using discharge electrodes having such gradually sloping arc-shaped tips. Further, in some cases, the pointed protruding portions on the tips of the discharge electrodes may essentially be formed into arc shapes, as shown in Fig. 14, by the effect of multiple discharge operations. A surge absorber of the present invention effectively operated even after a discharging surface became arc-shaped due to repeated use.

In the present invention, the shapes of the lead terminal tips can be arbitrarily selected, as explained above. For instance, the press die 34 of Fig. 4 may be shaped to have grid-like grooves formed on an end thereof, as shown in Fig. 15. Similar grid-like grooves 18b would then be formed on the surface of the discharge electrode 18 disposed on the tip of the lead terminal 14. As an enlarged surface area can be employed for inducing discharge when a surge voltage is applied, this embodiment is useful when surge absorption should be performed from relatively low voltages.

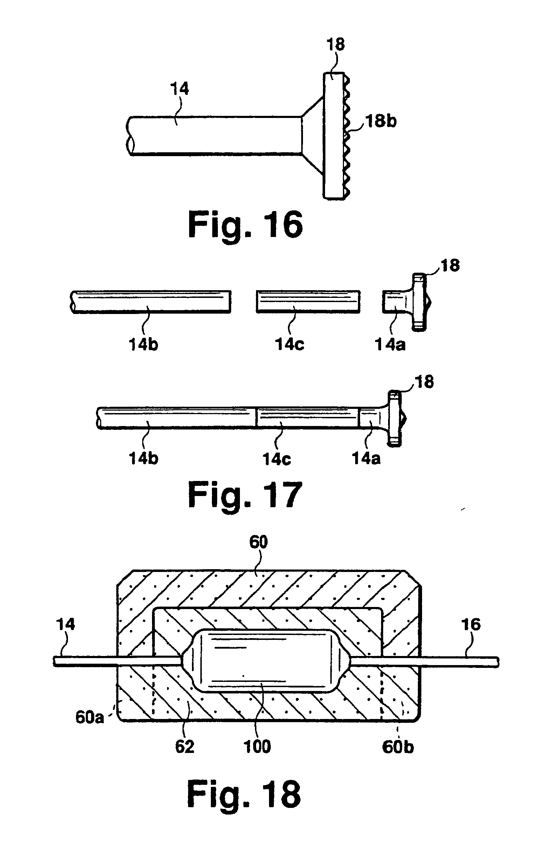

In each of the above-described embodiments, the lead terminal 14 is composed of Dumet wires. However, as Dumet wires are typically more expensive compared to lead wires made of a single material, using a long lead length would increase the cost of the surge absorber which would be disadvantageous. According to another embodiment of the present invention shown in Fig. 17, the lead terminal 14 comprises the tip portion 14a, the lead tail portion 14b, and the welding portion 14c disposed between the two portions 14a,14b. The tip portion 14a and the tail portion 14b are composed of inexpensive single-material wire, while only the welding portion 14c that welds with a sealing spacer is made of a combined lead wire such as Dumet wire. Connections between the portions 14a and 14c and the portions 14b and 14c can be made easily by welding, and, as a whole, an inexpensive lead terminal is obtained.

Fig. 18 illustrates the surge absorber without chips of the present invention incorporated in a reinforcement package. In cases when external force is applied to a surge absorber or if a surge absorber is used in an environment with vibrations, the housing may be damaged. In such cases, it is preferable to insert the entire surge absorber 100 in a ceramic package 60 and fix in position by molding with ceramic filler 62, as shown in Fig. 18. The package 60 is box-shaped and is provided with grooves 60a,60b on a portion thereof. The lead terminals 14,16 of the surge absorber 100 are inserted in these grooves 60a,60b. In this state, the empty space inside the package 60 is filled with a ceramic material, and the entire unit is hardened. According to such an embodiment, a surge absorber can be obtained that has a sufficient mechanical strength for use in an electronic circuit located near a motor or other components. Packaging material is obviously not limited to ceramic. Materials such as plastic and metal can also be used.

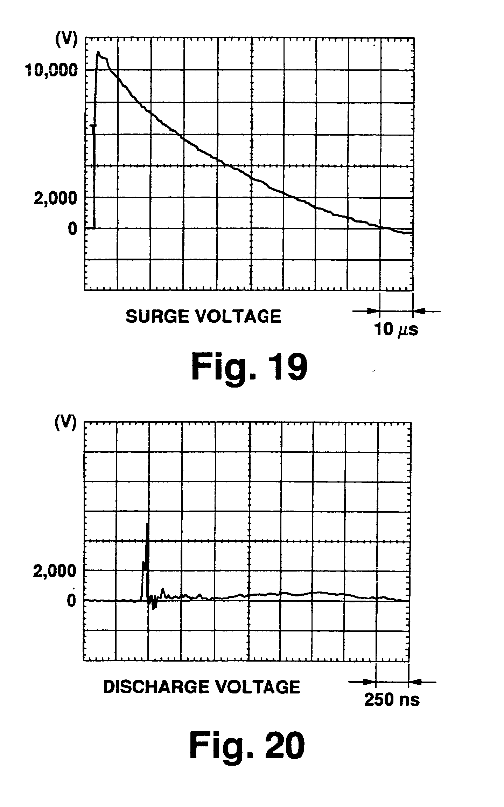

Fig. 19 shows a waveform of a surge applied to a preferred embodiment of the present invention illustrated in Fig. 1. The surge voltage is 11,120 volts. Fig. 20 shows the state of the discharge voltage obtained when the surge voltage of Fig. 19 is applied to a 5,000-volt surge absorber of the present invention shown in Fig. 1. Surge absorption operation was activated at 5,280 volts. After approximately 70ns, the voltage is lowered to about 300 volts leaving almost no residual voltage and producing no follow-current.

According to the present invention, discharge electrodes facing one another inside a housing can be formed in a simple structure in the manners described above. The present invention provides a surge absorber having a long service life, excellent durability, and a broad range of applications in electrical devices.

## Claims

1. A surge absorber without chips, comprising:
- a pair of lead terminals (14, 16) having broadened tips forming discharge electrodes (18, 20), and
- a housing (10) made of a non-conductive material,
- wherein said discharge electrodes (18, 20) are held in a position facing one another at a predetermined distance which defines a switching voltage at which the surge absorber starts to consume and to absorb electrical energy by converting the electrical energy into light energy,
**characterized in that**,
- a sealing spacer (22, 24) is fitted and fixed on the lead portion of each lead terminal (14, 16),
- said sealing spacers are inserted in the open ends on both sides of said housing (10) and are fixed airtightly on the housing (10), and
- the switching voltage of the surge absorber has been set by positioning the sealing spacers (22, 24) with respect to one another in the housing (10) for adjusting the distance between the discharge electrodes (18, 20) before the sealing spacers (22, 24) have been fixed airtightly to the housing (10).

2. The surge absorber without chips defined in claim 1, wherein: said two sealing spacers (22, 25) have been fixed airtightly by having been welded on an inside wall of said housing (10) while the discharge electrodes (18, 20) were held in positon facing one another at said predetermined distance.

3. The surge absorber without chips defined in Claim 1 or Claim 2, wherein:
an air chamber (12) provided in the housing (10) is filled with clean, dry air, or a mixed gas comprising clean, dry air and an inert gas or hydrogen gas.

4. The surge absorber without chips defined in Claim 3, wherein:
the clean, dry air sealed in the air chamber (12) has a relative humidity of 5% or less, and a degree of cleanliness of 99.99% (0.5 µmDOP), which is higher than the degree of cleanliness obtained through filtering normal air.

5. The surge absorber without chips defined in Claim 1 or Claim 2, wherein:
said sealing spacers (22, 24) have a shape of a sphere or a cylinder with a central fitting through-hole (22a) in which the lead portions of the lead terminals (14, 16) are inserted.

6. The surge absorber without chips defined in Claim 1 or Claim 2, wherein:
the lead terminals (14, 16) are formed of Dumet wires.

7. The surge absorber without chips defined in Claim 1 or Claim 2, wherein:
the lead terminals (14, 16) are formed of combined lead wires in which portions that have been welded with the sealing spacers (22, 24) are composed of Dumet wires.

## Revendications

1. Limiteur de surtensions sans puces, comprenant :
- deux extrémités (14, 16) de fil conducteur ayant des pointes élargies formant électrodes (18, 20) de décharge, et
- un boîtier (10) fait d'un matériau non conducteur,
- dans lequel lesdites électrodes de décharge (18, 20) sont maintenues dans une position en vis-à-vis à une distance prédéterminée qui définit une tension de commutation à laquelle le limiteur de surtension commence à consommer et à absorber l'énergie électrique en convertissant l'énergie électrique en énergie lumineuse,
***caractérisé en ce que***
- une garniture intercalaire d'étanchéité (22, 24) est placée et fixée sur la portion fil conducteur de chaque extrémité (14, 16) de fil conducteur,
- lesdites garnitures intercalaires d'étanchéité sont insérées dans les extrémités ouvertes des deux côtés dudit boîtier (10) et sont fixées sur le boîtier (10) de manière étanche à l'air, et
- la tension de commutation du limiteur de surtension a été réglée par le positionnement des garnitures intercalaires d'étanchéité (22, 24) l'une par rapport à l'autre dans le boîtier (10) de manière à ajuster la distance entre les électrodes de décharge (18, 20) avant que les garnitures intercalaires d'étanchéité (22, 24) aient été fixées au boîtier (10) de manière étanche à l'air.

2. Limiteur de surtension sans puces selon la Revendication 1, dans lequel : lesdites deux garnitures intercalaires d'étanchéité (22, 24) ont été fixées de manière étanche à l'air en ayant été soudées sur une paroi intérieure dudit boîtier (10) pendant que les électrodes de décharge (18, 20) étaient maintenues en position de vis-à-vis à ladite distance prédéterminée.

3. Limiteur de surtension sans puces selon la Revendication 1 ou la Revendication 2, dans lequel :
une chambre (12) à air ménagée dans le boîtier (10) est remplie d'air sec propre ou d'un mélange de gaz contenant de l'air sec propre et un gaz inerte ou de l'hydrogène gazeux.

4. Limiteur de surtension sans puces selon la Revendication 3, dans lequel :
l'air sec propre contenu dans la chambre (12) à air a une humidité relative égale ou inférieure à 5 %, et un degré de propreté de 99,99 % (0,5 µmDOP) qui est supérieur au degré de propreté obtenu par filtrage d'air normal.

5. Limiteur de surtension sans puces selon la Revendication 1 ou la Revendication 2, dans lequel :
lesdites garnitures intercalaires d'étanchéité (22, 24) ont la forme d'une sphère ou d'un cylindre avec un trou traversant central de montage (22a) dans lequel sont insérées les portions fil conducteur des extrémités (14, 16) de fil conducteur.

6. Limiteur de surtension sans puces selon la Revendication 1 ou la Revendication 2, dans lequel :
les extrémités (14, 16) de fil conducteur sont formées de fils Dumet.

7. Limiteur de surtension sans puces selon la Revendication 1 ou la Revendication 2, dans lequel :
les extrémités (14, 16) de fil conducteur sont formées de fils conducteurs combinés dans lesquels des portions qui ont été soudées aux garnitures intercalaires d'étanchéité (22, 24) sont composées de fils Dumet.

## Patentansprüche

1. Überspannungsableiter ohne Chips, der aufweist:
- ein Paar Leitungsenden (14, 16) mit verbreiterten Spitzen, die Entladungselektroden (18, 20) bilden, und
- ein Gehäuse (10) aus einem nichtleitenden Material,
- wobei die Entladungselektroden (18, 20) in einer Position gehalten werden, in der sie einander mit einem vorbestimmten Abstand gegenüberliegen, der eine Schaltspannung definiert, bei der der Überspannungsableiter beginnt, elektrische Energie durch das Umwandeln der elektrischen Energie in Lichtenergie zu verbrauchen und zu absorbieren,
**dadurch gekennzeichnet,**
- **dass** ein abdichtender Abstandshalter (22, 24) auf dem Leitungsabschnitt jedes Leitungsendes (14, 16) angebracht und befestigt ist,
- **dass** die abdichtenden Abstandshalter in die offenen Enden auf beiden Seiten des Gehäuses (10) eingeführt werden und luftdicht am Gehäuse (10) befestigt werden, und
- **dass** die Schaltspannung des Überspannungsableiters durch Positionieren der abdichtenden Abstandshalter (22, 24) in Bezug zueinander im Gehäuse (10) zum Einstellen des Abstands zwischen den Entladungselektroden (18, 20) eingestellt wurde, bevor die abdichtenden Abstandshalter (22, 24) luftdicht am Gehäuse (10) befestigt wurden.

2. Überspannungsableiter ohne Chips nach Anspruch 1,
wobei die zwei abdichtenden Abstandshalter (22, 24) luftdicht befestigt wurden, indem sie an einer Innenwand des Gehäuses (10) verschweißt wurden, während die Entladungselektroden (18, 20) in der einander gegenüberliegenden Position im vorbestimmten Abstand gehalten wurden.

3. Überspannungsableiter ohne Chips nach Anspruch 1 oder Anspruch 2,
wobei eine Luftkammer (12), die in dem Gehäuse (10) vorgesehen ist, mit sauberer, trockener Luft oder einem gemischten Gas, das saubere, trockene Luft und ein Inertgas oder Wasserstoffgas aufweist, gefüllt ist.

4. Überspannungsableiter ohne Chips nach Anspruch 3,
wobei die saubere, trockene Luft, die in der Luftkammer (12) eingeschlossen ist, eine relative Feuchtigkeit von 5 % oder weniger hat und einen Grad an Sauberkeit von 99,99 % (0,5 µm DOP), was höher ist, als der Grad an Sauberkeit, der durch Filtern normaler Luft erhalten wird, aufweist.

5. Überspannungsableiter ohne Chips nach Anspruch 1 oder Anspruch 2,
wobei die abdichtenden Abstandshalter (22, 24) die Form einer Kugel oder eines Zylinders mit einem zentralen, passenden Durchgangsloch (22a) haben, in welches die Leitungsabschnitte der Leitungsenden (14, 16) eingeführt sind.

6. Überspannungsableiter ohne Chips nach Anspruch 1 oder Anspruch 2,
wobei die Leitungsenden (14, 16) aus Dumet-Drähten gebildet sind.

7. Überspannungsableiter ohne Chips nach Anspruch 1 oder Anspruch 2,
wobei die Leitungsenden (14, 16) aus kombinierten Leitungsdrähten gebildet werden, bei denen die Abschnitte, die mit den Abstandshaltern (22, 24) verschweißt wurden, aus Dumet-Drähten zusammengesetzt sind.
